# EUROPEAN PATENT SPECIFICATION

(11) **EP 4 354 156 B1**
(45) Date of publication and mention of the grant of the patent: **15.07.2026**
(21) Application number: 23195172.4
(22) Date of filing: 04.09.2023
(51) Int. Cl.: G01R 19/00, G01R 19/165, G01R 31/28, G01R 15/14

(54) **DIAGNOSTIC CIRCUIT**
DIAGNOSESCHALTUNG
CIRCUIT DE DIAGNOSTIC

(30) Priority: 11.10.2022 US 202218045517
(43) Date of publication of application: 17.04.2024
(73) Proprietor: The Boeing Company, Arlington, VA 22202 (US)
(72) Inventor: DAYTON, IAN M., Arlington, 22202 (US); NOWAKOWSKI, MARK EDWARD, Arlington, 22202 (US)
(74) Representative: Bugnion S.p.A. - US1

(56) References cited:
- US-A- 5 045 788
- US-A1- 2019 079 145
- US-B1- 10 574 251

## Description

### FIELD

The present disclosure generally relates to a diagnostic circuit, and more specifically to a diagnostic circuit that includes two superconducting quantum interference devices.

### BACKGROUND

In many applications, complementary metal-oxide-semiconductor (CMOS) circuits operate at cryogenic temperatures (*e.g*., less than or equal to 4 K corresponding to liquid helium or less than or equal to 77 K corresponding to liquid nitrogen). Methods for monitoring the performance of such CMOS circuits include sending output signals of the CMOS circuit from the location at cryogenic temperatures to a location at room temperature through long wires and/or other conditioning circuitry. The output signals are then analyzed but are typically affected by thermal noise which complicates the analysis.

Document US 10,574,251 B1, according to its abstract, states that a Josephson analog-to-digital converter system includes a control line inductively coupled to an input signal line on which an input analog signal is provided. The input signal line can be inductively coupled to the control line to propagate an induced input current that is based on the input analog signal on the control line. The system also includes at least one Josephson transmission line (JTL) stage that is biased via a DC bias current and is configured to generate an output pulse in response to the induced input current and the DC bias current exceeding a predetermined threshold current associated with the at least one JTL stage.

Document US 2019/079145 A1, according to its abstract, states that a transfer function of a sensing device including a plurality of sensors is automatically adjusted based on a power level of an incident electromagnetic signal detected by the plurality of sensors. Each of the plurality of sensors is associated with a unique transfer function. An output from one of the plurality of sensors associated with a particular transfer function is automatically selected based on a power level of the detected incident electromagnetic signal. Responsive to a change in the power level of the detected electromagnetic signal, another output from a different one of the plurality of sensors associated with a different transfer function is selected. The transfer function is adjusted over time by automatically selecting outputs from different ones of the plurality of sensors based on changes in the power level of the detected incident electromagnetic signal.

As such, a need exists for more accurate circuits and methods for monitoring the performance of circuits operating at cryogenic temperatures.

### SUMMARY

One aspect of the disclosure is a method of operating a diagnostic circuit according to the invention as defined in independent claim 1.

Another aspect of the disclosure is a diagnostic circuit according to the invention as defined in independent claim 4.

Advantageous embodiments are defined in the dependent claims.

By the term "about" or "substantially" with reference to amounts or measurement values described herein, it is meant that the recited characteristic, parameter, or value need not be achieved exactly, but that deviations or variations, including for example, tolerances, measurement error, measurement accuracy limitations and other factors known to those of skill in the art, may occur in amounts that do not preclude the effect the characteristic was intended to provide.

The features, functions, and advantages that have been discussed can be achieved independently in various examples or may be combined in yet other examples further details of which can be seen with reference to the following description and drawings.

### BRIEF DESCRIPTION OF THE DRAWINGS

The novel features believed characteristic of the illustrative examples are set forth in the appended claims. The illustrative examples, however, as well as a preferred mode of use, further objectives and descriptions thereof, will best be understood by reference to the following detailed description of an illustrative example of the present disclosure when read in conjunction with the accompanying Figures.
- Figure 1 is a schematic diagram of a diagnostic circuit, according to an example.
- Figure 2 shows an output of a circuit operating at a cryogenic temperature, according to an example.
- Figure 3 shows an output of a diagnostic circuit, according to an example.
- Figure 4 is a block diagram of a method, according to an example.
- Figure 5 is a block diagram of a method, according to an example.

### DETAILED DESCRIPTION

As noted above, a need exists for more accurate circuits and methods for monitoring the performance of circuits operating at cryogenic temperatures. Accordingly, this disclosure includes a diagnostic circuit and methods for its operation. The diagnostic circuit includes an input port configured to receive an input current and a first superconducting quantum interference device (SQUID) inductively coupled to the input port. The first SQUID is configured to generate a first output in the form of: a first voltage (e.g. zero) in response to the input current being less than a first threshold current and a second voltage *(e.g.,* 0.025 mV) in response to the input current being greater than the first threshold current. The diagnostic circuit also includes a second SQUID inductively coupled to the input port. The second SQUID is configured to generate a second output in the form of: a third voltage (*e.g*., zero) in response to the input current being less than a second threshold current and a fourth voltage *(e.g.,* 0.025 mV) in response to the input current being greater than the second threshold current. The input current can be a direct output of a CMOS circuit operating at a cryogenic temperature or a representation of such an output of the CMOS circuit. Typically, the second threshold current is greater than the first threshold current such that the output transition of the first SQUID corresponds to an input current that is less than the input current that corresponds to the output transition of the second SQUID.

More generally, the diagnostic circuit can include an arbitrary number of SQUIDs that are connected in series. Each SQUID is designed to have a (*e.g.,* unique) threshold current such that the input current exceeding the threshold current causes the SQUID to change its output from a first voltage *(e.g.,* zero) to a second voltage *(e.g.,* 0.025 mV). That is, the Josephson junction area for each SQUID, the material of each SQUID, and the operating temperature of the diagnostic circuit are chosen to achieve the desired threshold current for each SQUID. The input current decreasing to be less than the threshold current for a given SQUID causes the output of that SQUID to revert from the second voltage back to the first voltage. In some examples, the number of SQUIDs of the diagnostic circuit that generate a "high" voltage (*e.g.,* 0.025 mV) instead of a "low" voltage (*e.g*., zero) is proportional to the voltage level being generated by the CMOS circuit. In other words, the output voltage of the series connection of the SQUIDs is proportional to the voltage level of the CMOS circuit. Thus, the diagnostic circuit acts as a sort of analog-to-digital converter that is configured to operate at cryogenic temperatures.

Due to this quantization of the output of the series connection of the SQUIDs, the output is less vulnerable to thermal noise. The diagnostic circuit can operate at the cryogenic temperature in close proximity to the CMOS circuit being monitored. Each SQIUD can respond quickly to changes in the input current, for example, within 100 ps.

Disclosed examples will now be described more fully hereinafter with reference to the accompanying Drawings, in which some, but not all of the disclosed examples are shown. Indeed, several different examples may be described and should not be construed as limited to the examples set forth herein. Rather, these examples are described so that this disclosure will be thorough and complete and will fully convey the scope of the disclosure to those skilled in the art.

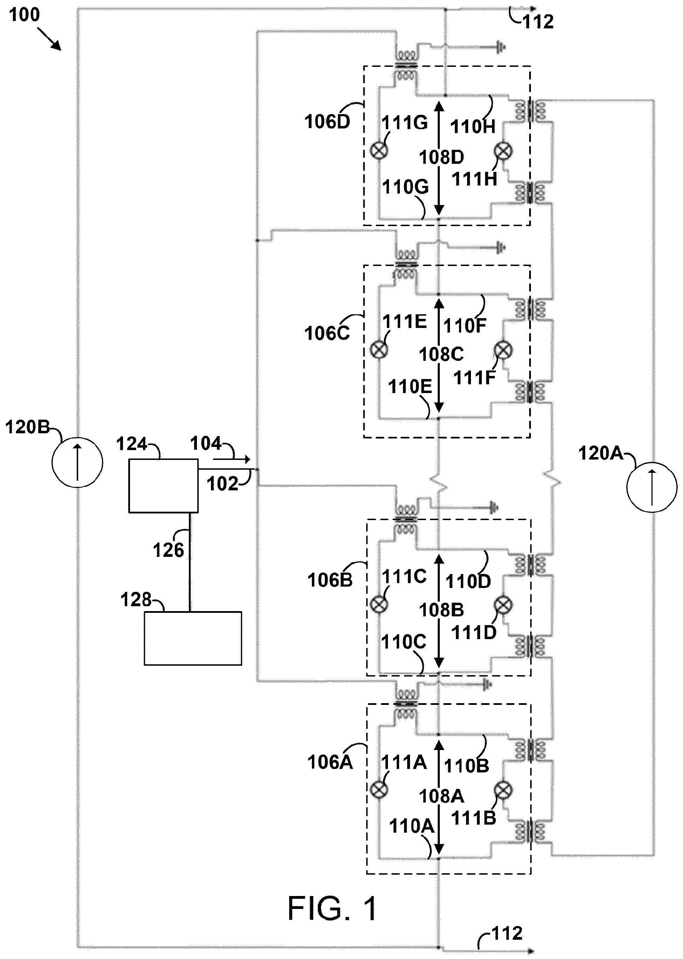

Figure 1 is a schematic diagram of a diagnostic circuit 100 that includes an input port 102 configured to receive an input current 104. The diagnostic circuit 100 also includes a superconducting quantum interference device (SQUID) 106A inductively coupled to the input port 102 via the terminal 110B. The SQUID 106A is configured to generate an output 108A in the form of a first voltage (*e.g*., zero) in response to the input current 104 being less than a first threshold current and a second voltage (*e.g.,* 0.025 mV or any voltage greater than the first voltage) in response to the input current 104 being greater than the first threshold current. The SQUID 106A is configured to generate the output 108A between the terminal 110A and the terminal 110B of the SQUID 106A.

The SQUID 106A includes a Josephson junction 111A and a Josephson junction 111B. Thus, the SQUID 106A forms a superconducting loop that includes two different superconducting materials that meet at the Josephson junction 111A and the Josephson junction 111B. The terminal 110A and the terminal 110B are inductively coupled to a current source 120A. The terminal 110A is also connected to the current source 120B. The terminal 110B is connected to the current source 120B via the SQUID 106B (*e.g.,* via the terminal 110C), the SQUID 106C, and the SQUID 106D. The current induced within the SQUID 106A by the current source 120A and the current injected into the SQUID 106A by the current source 120B, together with the cross sectional areas of the Josephson junction 111A and the Josephson junction 111B, the choice of materials that form the Josephson junction 111A and the Josephson junction 111B, and the operating temperature of the SQUID 106A all amount to design variables or constraints that determine the threshold current that corresponds to the SQUID 106A.

The diagnostic circuit 100 also includes a superconducting quantum interference device (SQUID) 106B inductively coupled to the input port 102 via the terminal 110D. The SQUID 106B is configured to generate an output 108B in the form of a third voltage (*e.g*., zero) in response to the input current 104 being less than a second threshold current and a fourth voltage (*e.g.,* 0.025 mV or any voltage greater than the third voltage) in response to the input current 104 being greater than the second threshold current. The SQUID 106B is configured to generate the output 108B between the terminal 110C and the terminal 110D of the SQUID 106B.

The SQUID 106B includes a Josephson junction 111C and a Josephson junction 111D. Thus, the SQUID 106B forms a superconducting loop that includes two different superconducting materials that meet at the Josephson junction 111C and the Josephson junction 111D. The terminal 110C and the terminal 110D are inductively coupled to the current source 120A. The terminal 110C is also connected to the current source 120B via the SQUID 106A (*e.g.,* via the terminal 110B). The terminal 110D is connected to the current source 120B via the SQUID 106C *(e.g.,* via the terminal 110E) and the SQUID 106D. The current induced within the SQUID 106B by the current source 120A and the current injected into the SQUID 106B by the current source 120B, together with the cross sectional areas of the Josephson junction 111C and the Josephson junction 111D, the choice of materials that form the Josephson junction 111C and the Josephson junction 111D, and the operating temperature of the SQUID 106B all amount to design variables or constraints that determine the threshold current that corresponds to the SQUID 106B.

The diagnostic circuit 100 also includes a superconducting quantum interference device (SQUID) 106C inductively coupled to the input port 102 via the terminal 110F. The SQUID 106C is configured to generate an output 108C in the form of a fifth voltage (*e.g*., zero) in response to the input current 104 being less than a third threshold current and a sixth voltage (*e.g.,* 0.025 mV or any voltage greater than the fifth voltage) in response to the input current 104 being greater than the third threshold current. The SQUID 106C is configured to generate the output 108C between the terminal 110E and the terminal 110F of the SQUID 106C.

The SQUID 106C includes a Josephson junction 111E and a Josephson junction 111F. Thus, the SQUID 106C forms a superconducting loop that includes two different superconducting materials that meet at the Josephson junction 111E and the Josephson junction 111F. The terminal 110E and the terminal 110F are inductively coupled to the current source 120A. The terminal 110E is also connected to the current source 120B via the SQUID 106A and the SQUID 106B (*e.g.,* via the terminal 110D). The terminal 110F is connected to the current source 120B via the SQUID 106D (*e.g.,* via the terminal 110G). The current induced within the SQUID 106C by the current source 120A and the current injected into the SQUID 106C by the current source 120B, together with the cross sectional areas of the Josephson junction 111E and the Josephson junction 111F, the choice of materials that form the Josephson junction 111E and the Josephson junction 111F, and the operating temperature of the SQUID 106C all amount to design variables or constraints that determine the threshold current that corresponds to the SQUID 106C.

The diagnostic circuit 100 also includes a superconducting quantum interference device (SQUID) 106D inductively coupled to the input port 102 via the terminal 110H. The SQUID 106D is configured to generate an output 108D in the form of a seventh voltage (*e.g.*, zero) in response to the input current 104 being less than a fourth threshold current and an eighth voltage (*e.g.,* 0.025 mV or any voltage greater than the seventh voltage) in response to the input current 104 being greater than the fourth threshold current. The SQUID 106D is configured to generate the output 108D between the terminal 110G and the terminal 110H of the SQUID 106D.

The SQUID 106D includes a Josephson junction 111G and a Josephson junction 111H. Thus, the SQUID 106D forms a superconducting loop that includes two different superconducting materials that meet at the Josephson junction 111G and the Josephson junction 111H. The terminal 110G and the terminal 110H are inductively coupled to the current source 120A. The terminal 110H is also connected to the current source 120B. The terminal 110G is connected to the current source 120B via the SQUID 106C (*e.g.,* via the terminal 110F), the SQUID 106B, and the SQUID 106A. The current induced within the SQUID 106D by the current source 120A and the current injected into the SQUID 106D by the current source 120B, together with the cross sectional areas of the Josephson junction 111G and the Josephson junction 111H, the choice of materials that form the Josephson junction 111G and the Josephson junction 111H, and the operating temperature of the SQUID 106D all amount to design variables or constraints that determine the threshold current that corresponds to the SQUID 106D.

Generally, the first threshold current corresponding to the SQUID 106A is less than the second threshold current corresponding to the SQUID 106B. The second threshold current corresponding to the SQUID 106B is generally less than the third threshold current corresponding to the SQUID 106C. The third threshold current corresponding to the SQUID 106C is generally less than the fourth threshold current corresponding to the SQUID 106D.

Additionally or alternatively, a difference between the first threshold current and the second threshold current can be substantially equal to a difference between the second threshold current and the third threshold current. The difference between the second threshold current and the third threshold current can be equal to the difference between the third threshold current and the fourth threshold current.

As such, the diagnostic circuit 100 is configured to generate an output voltage 112 representing a sum of the output 108A, the output 108B, the output 108C, and the output 108D. The output voltage 112 indicates a range of current that includes the present value of the input current 104. Figure 1 also shows a CMOS circuit 128 that is operating at a cryogenic temperature. The CMOS circuit 128 generates a CMOS output voltage 126 that is provided to conditioning circuitry 124. The conditioning circuitry 124 generates the input current 104 such that the magnitude of the input current 104 is proportional to the magnitude of the CMOS output voltage 126.

In an example, the diagnostic circuit 100 receives, via the input port 102, the input current 104 that is less than a first threshold current that corresponds to the SQUID 106A. For example, the input current 104 is equal to 0.05 mA and the first threshold current is equal to 0.1 mA. In response, the SQUID 106A generates the output 108A in the form of a voltage that is equal to zero, the SQUID 106B generates the output 108B in the form of a voltage that is equal to zero, the SQUID 106C generates the output 108C in the form of a voltage that is equal to zero, and the SQUID 106D generates the output 108D in the form of a voltage that is equal to zero. This results in the output voltage 112 of the diagnostic circuit 100 being equal to zero.

Next, the diagnostic circuit 100 receives, via the input port 102, the input current 104 that is now greater than the first threshold current 0.1 mA and less than a second threshold current 0.2 mA that corresponds to the SQUID 106B. In response, the SQUID 106A generates the output 108A in the form of a voltage that is equal to 0.025 mV, the SQUID 106B generates the output 108B in the form of a voltage that is equal to zero, the SQUID 106C generates the output 108C in the form of a voltage that is equal to zero, and the SQUID 106D generates the output 108D in the form of a voltage that is equal to zero. This results in the output voltage 112 of the diagnostic circuit 100 being equal to 0.025 mV.

Next, the diagnostic circuit 100 receives, via the input port 102, the input current 104 that is now greater than the second threshold current 0.2 mA and less than a third threshold current 0.3 mA that corresponds to the SQUID 106C. In response, the SQUID 106A generates the output 108A in the form of a voltage that is equal to 0.025 mV, the SQUID 106B generates the output 108B in the form of a voltage that is equal to 0.025 mV, the SQUID 106C generates the output 108C in the form of a voltage that is equal to zero, and the SQUID 106D generates the output 108D in the form of a voltage that is equal to zero. This results in the output voltage 112 of the diagnostic circuit 100 being equal to 0.05 mV.

Next, the diagnostic circuit 100 receives, via the input port 102, the input current 104 that is now greater than the third threshold current 0.3 mA and less than a fourth threshold current 0.4 mA that corresponds to the SQUID 106D. In response, the SQUID 106A generates the output 108A in the form of a voltage that is equal to 0.025 mV, the SQUID 106B generates the output 108B in the form of a voltage that is equal to 0.025 mV, the SQUID 106C generates the output 108C in the form of a voltage that is equal to 0.025 mV, and the SQUID 106D generates the output 108D in the form of a voltage that is equal to zero. This results in the output voltage 112 of the diagnostic circuit 100 being equal to 0.075 mV.

Next, the diagnostic circuit 100 receives, via the input port 102, the input current 104 that is now greater than the fourth threshold current 0.4 mA. In response, the SQUID 106A generates the output 108A in the form of a voltage that is equal to 0.025 mV, the SQUID 106B generates the output 108B in the form of a voltage that is equal to 0.025 mV, the SQUID 106C generates the output 108C in the form of a voltage that is equal to 0.025 mV, and the SQUID 106D generates the output 108D in the form of a voltage that is equal to 0.025 mV. This results in the output voltage 112 of the diagnostic circuit 100 being equal to 0.1 mV.

Generally, the diagnostic circuit 100 can include any arbitrary number of SQUIDS connected in series such that the output voltage 112 can be generated at any number of predefined voltage levels corresponding to different levels of the input current 104.

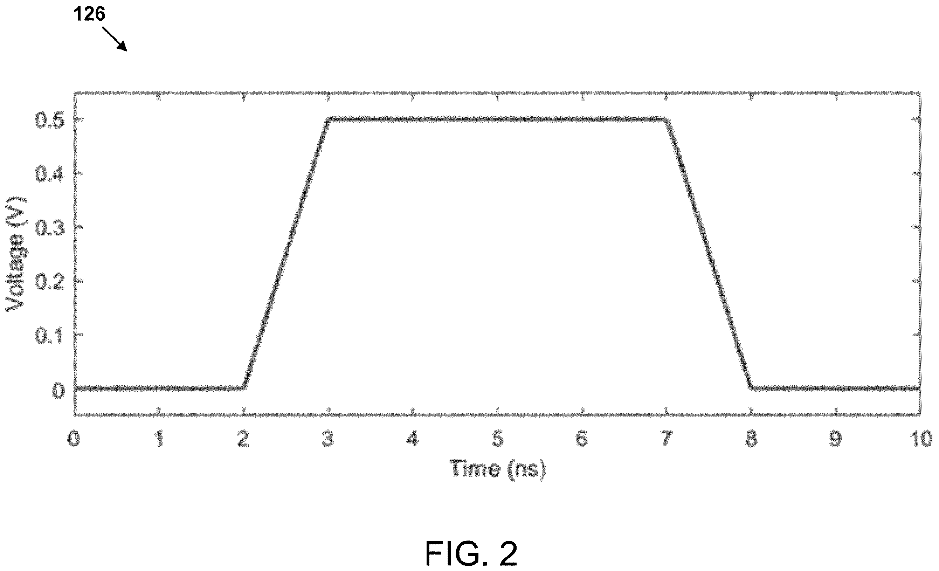

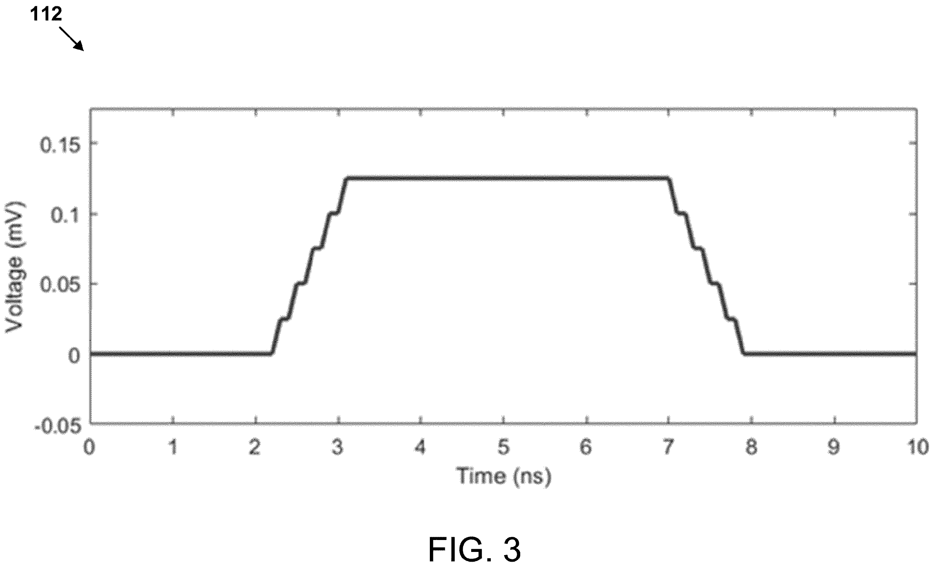

Figure 2 shows the CMOS output voltage 126 of the CMOS circuit 128 operating at a cryogenic temperature. From 0 ns to 2 ns, the CMOS output voltage 126 is equal to 0 V. From 2 ns to 3 ns, the CMOS output voltage 126 increases linearly from 0 V to 0.5 V. From 3 ns to 7 ns, the CMOS output voltage 126 remains at 0.5 V. From 7 ns to 8 ns, the CMOS output voltage 126 decreases linearly from 0.5 V to 0 V. From 8 ns to 10 ns, the output voltage remains at 0 V. Figure 3 shows the output voltage 112 of the diagnostic circuit 100, representing the CMOS output voltage 126 of the CMOS circuit 128 shown in Figure 2. As shown, from 0 ns to 2 ns the output voltage 112 is equal to 0 V which corresponds to the CMOS output voltage 126 being equal to 0 V. From 2 ns to 3 ns, the output voltage 112 transitions from 0 mV to 0.025 mV, from 0.025 mV to 0.05 mV, from 0.05 mV to 0.075 mV, from 0.075 mV to 0.1 mV, and from 0.1 mV to 0.125 mV, based on the CMOS output voltage 126 transitioning from less than 0.05 V to greater than 0.05 V, from less than 0.15 V to greater than 0.15 V, from less than 0.25 V to greater than 0.25 V, from less than 0.35 V to greater than 0.35 V, and from less than 0.45 V to greater than 0.45 V, respectively. From 3 ns to 7 ns, the output voltage 112 remains at 0.125 mV based on the CMOS output voltage 126 being equal to 0.5 V *(e.g.,* greater than 0.45 V). From 7 ns to 8 ns, the output voltage 112 transitions from 0.125 mV to 0.1 mV, from 0.1 mV to 0.075 mV, from 0.075 mV to 0.05 mV, from 0.05 mV to 0.025 mV, and from 0.025 mV to 0 mV, based on the CMOS output voltage 126 transitioning from greater than 0.45 V to less than 0.45 V, from greater than 0.35 V to less than 0.35 V, from greater than 0.25 V to less than 0.25 V, from greater than 0.15 V to less than 0.15 V, and from greater than 0.05 V to less than 0.05 V, respectively.

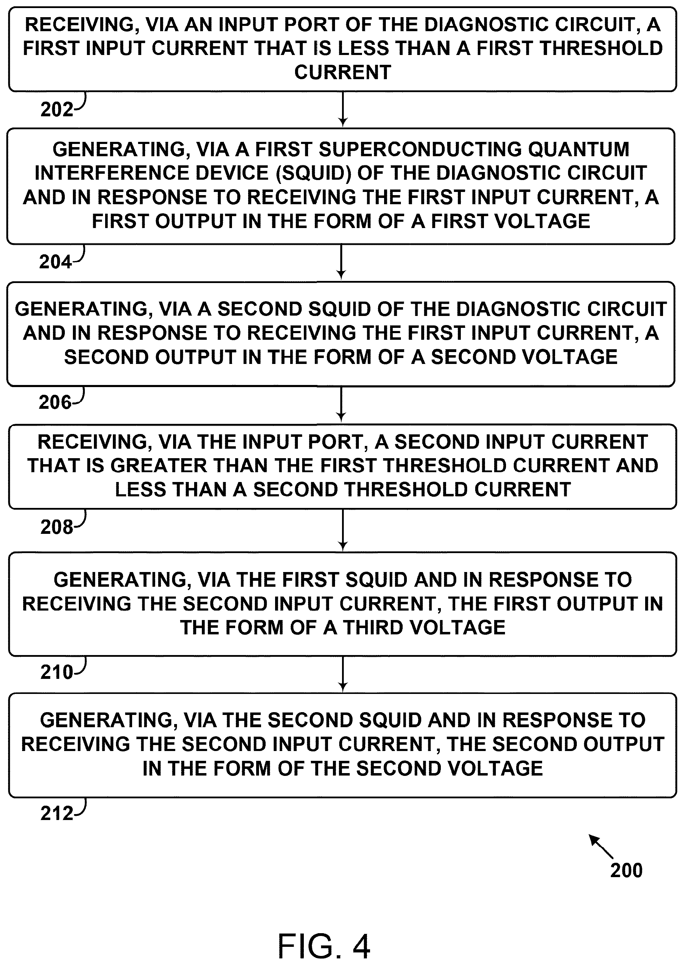

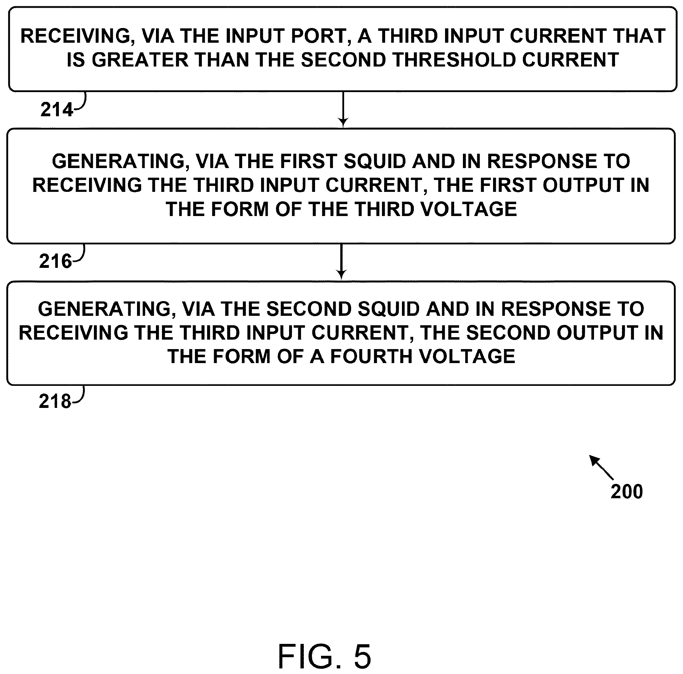

Figure 4 and Figure 5 are block diagrams of a method 200 for operating the diagnostic circuit 100. As shown in Figure 4 and Figure 5, the method 200 includes one or more operations, functions, or actions as illustrated by blocks 202, 204, 206, 208, 210, 212, 214, 216, and 218. Although the blocks are illustrated in a sequential order, these blocks may also be performed in parallel, and/or in a different order than those described herein. Also, the various blocks may be combined into fewer blocks, divided into additional blocks, and/or removed based upon the desired implementation.

At block 202, the method 200 includes receiving, via the input port 102 of the diagnostic circuit 100, the input current 104 that is less than a first threshold current. Functionality related to block 202 is described above with reference to Figures 1-3.

At block 204, the method 200 includes generating, via the SQUID 106A of the diagnostic circuit 100 and in response to receiving the input current 104 that is less than the first threshold current, the output 108A in the form of a first voltage. Functionality related to block 204 is described above with reference to Figures 1-3.

At block 206, the method 200 includes generating, via the SQUID 106B of the diagnostic circuit 100 and in response to receiving the input current 104 that is less than the first threshold current, the output 108B in the form of a second voltage. Functionality related to block 206 is described above with reference to Figures 1-3.

At block 208, the method 200 includes receiving, via the input port 102, the input current 104 that is greater than the first threshold current and less than a second threshold current. Functionality related to block 208 is described above with reference to Figures 1-3.

At block 210, the method 200 includes generating, via the SQUID 106A and in response to receiving the input current 104 that is greater than the first threshold current and less than the second threshold current, the output 108A in the form of a third voltage. Functionality related to block 210 is described above with reference to Figures 1-3.

At block 212, the method 200 includes generating, via the SQUID 106B and in response to receiving the input current 104 that is greater than the first threshold current and less than the second threshold current, the output 108B in the form of the second voltage. Functionality related to block 212 is described above with reference to Figures 1-3.

At block 214, the method 200 includes receiving, via the input port 102, the input current 104 that is greater than the second threshold current. Functionality related to block 214 is described above with reference to Figures 1-3.

At block 216, the method 200 includes generating, via the SQUID 106A and in response to receiving the input current 104 that is greater than the second threshold current, the output 108A in the form of the third voltage. Functionality related to block 216 is described above with reference to Figures 1-3.

At block 218, the method 200 includes generating, via the SQUID 106B and in response to receiving the input current 104 that is greater than the second threshold current, the output 108B in the form of a fourth voltage. Functionality related to block 218 is described above with reference to Figures 1-3.

The description of the different advantageous arrangements has been presented for purposes of illustration and description, and is not intended to be exhaustive or limited to the examples in the form disclosed. Many modifications and variations will be apparent to those of ordinary skill in the art. Further, different advantageous examples may describe different advantages as compared to other advantageous examples. The example or examples selected are chosen and described in order to explain the principles of the examples, the practical application, and to enable others of ordinary skill in the art to understand the disclosure for various examples with various modifications as are suited to the particular use contemplated.

## Claims

1. A method (200) of operating a diagnostic circuit (100), the method (200) comprising:
receiving (202), via an input port (102) of the diagnostic circuit, a first input current (104) that is less than a first threshold current, wherein receiving (202) the first input current comprises receiving the first input current such that the first input current represents a state of a complementary metal-oxide semiconductor, CMOS, device operating at a cryogenic temperature, that is a temperature less than or equal to 4 K corresponding to liquid helium or less than or equal to 77 K corresponding to liquid nitrogen, said CMOS device being in close proximity to the diagnostic circuit (100);
generating (204), via a first superconducting quantum interference device, SQUID, (106A) of the diagnostic circuit and in response to receiving the first input current, a first output (108A) in the form of a first voltage;
generating (206), via a second SQUID (106B) of the diagnostic circuit and in response to receiving the first input current, a second output (108B) in the form of a second voltage;
receiving (208), via the input port, a second input current (104) that is greater than the first threshold current and less than a second threshold current;
generating (210), via the first SQUID and in response to receiving the second input current, the first output in the form of a third voltage;
generating (212), via the second SQUID and in response to receiving the second input current, the second output in the form of the second voltage;
receiving (214), via the input port, a third input current (104) that is greater than the second threshold current;
generating (216), via the first SQUID and in response to receiving the third input current, the first output in the form of the third voltage; and
generating (218), via the second SQUID and in response to receiving the third input current, the second output in the form of a fourth voltage,
said diagnostic circuit (100) being configured to generate an output voltage (112) representing a sum of the first output, the second output, and the third output.

2. The method (200) of claim 1, wherein a first difference between the first voltage and the third voltage is substantially equal to a second difference between the second voltage and the fourth voltage.

3. The method (200) of claim 1 or 2, wherein said diagnostic circuit (100) comprises:
an input port (102) configured to receive an input current (104);
a first superconducting quantum interference device, SQUID, (106A) inductively coupled to the input port (102), wherein the first SQUID (106A) is configured to generate a first output (108A) in the form of:
a first voltage in response to the input current (104) being less than a first threshold current, and
a second voltage in response to the input current (104) being greater than the first threshold current; and
a second SQUID (106B) inductively coupled to the input port (102), wherein the second SQUID (106B) is configured to generate a second output (108B) in the form of:
a third voltage in response to the input current (104) being less than a second threshold current, and
a fourth voltage in response to the input current (104) being greater than the second threshold current.

4. A diagnostic circuit (100) configured to carry out the method (200) according to any one of the preceding claims, comprising:
an input port (102) configured to receive an input current (104);
a first superconducting quantum interference device, SQUID, (106A) inductively coupled to the input port (102), wherein the first SQUID (106A) is configured to generate a first output (108A) in the form of:
a first voltage in response to the input current (104) being less than a first threshold current, and
a second voltage in response to the input current (104) being greater than the first threshold current; and
a second SQUID (106B) inductively coupled to the input port (102), wherein the second SQUID (106B) is configured to generate a second output (108B) in the form of:
a third voltage in response to the input current (104) being less than a second threshold current, and
a fourth voltage in response to the input current (104) being greater than the second threshold current,
wherein the diagnostic circuit (100) is configured to generate an output voltage (112) representing a sum of the first output (108A), the second output (108B), and the third output (108C).

5. The diagnostic circuit (100) of claim 4, wherein the first SQUID (106A) comprises a first terminal (110A) and a second terminal (110B) and the first SQUID (106A) is configured to generate the first output (108A) between the first terminal (110A) and the second terminal (110B).

6. The diagnostic circuit (100) of claim 4 or 5, wherein the second SQUID (106B) comprises a third terminal (110C) and a fourth terminal (110D) and the second SQUID (106B) is configured to generate the second output (108B) between the third terminal (110C) and the fourth terminal (110D).

7. The diagnostic circuit (100) of any one of claims 4 to 6, wherein the second terminal (110B) is connected to the third terminal (110C).

8. The diagnostic circuit (100) of any one of claims 4 to 7, wherein the first voltage is substantially equal to zero or the first voltage is less than the second voltage.

9. The diagnostic circuit (100) of any one of claims 4 to 8, wherein the third voltage is substantially equal to zero or the third voltage is less than the fourth voltage.

10. The diagnostic circuit (100) of any one of claims 4 to 9, wherein a first difference between the first voltage and the second voltage is substantially equal to a second difference between the third voltage and the fourth voltage.

11. The diagnostic circuit (100) of any one of claims 4 to 10, wherein the first threshold current is less than the second threshold current.

12. The diagnostic circuit (100) of any one of claims 4 to 11, further comprising a third SQUID (106C) inductively coupled to the input port (102), wherein the third SQUID (106C) is configured to generate a third output (108C) in the form of:
a fifth voltage in response to the input current (104) being less than a third threshold current, and
a sixth voltage in response to the input current (104) being greater than the third threshold current,
wherein a first difference between the first threshold current and the second threshold current is substantially equal to a second difference between the second threshold current and the third threshold current.

13. The diagnostic circuit (100) of claim 12, wherein the fifth voltage is substantially equal to zero or the fifth voltage is less than the sixth voltage.

14. The diagnostic circuit (100) of claim 12, wherein a third difference between the first voltage and the second voltage is substantially equal to a fourth difference between the third voltage and the fourth voltage which is substantially equal to a fifth difference between the fifth voltage and the sixth voltage.

## Patentansprüche

1. Verfahren (200) zum Betreiben einer Diagnoseschaltung (100), wobei das Verfahren (200) aufweist:
Empfangen (202), über einen Eingangsport (102) der Diagnoseschaltung, eines ersten Eingangsstroms (104), der kleiner als ein erster Schwellenstrom ist, wobei das Empfangen (202) des ersten Eingangsstroms aufweist, den ersten Eingangsstrom derart zu empfangen, dass der erste Eingangsstrom einen Zustand einer komplementären Metalloxidhalbleiter-, CMOS-, Einrichtung repräsentiert, die bei einer kryogenen Temperatur arbeitet, die eine Temperatur kleiner oder gleich 4 K entsprechend flüssigem Helium oder kleiner oder gleich 77 K entsprechend flüssigem Stickstoff ist, wobei sich die CMOS-Einrichtung in enger Nähe zu der Diagnoseschaltung (100) befindet;
Erzeugen (204), über eine erste supraleitende Quanteninterferenzeinrichtung, SQUID, (106A) der Diagnoseschaltung und als Reaktion auf das Empfangen des ersten Eingangsstroms, eines ersten Ausgangs (108A) in der Form einer ersten Spannung;
Erzeugen (206), über eine zweite SQUID (106B) der Diagnoseschaltung und als Reaktion auf das Empfangen des ersten Eingangsstroms, eines zweiten Ausgangs (108B) in der Form einer zweiten Spannung;
Empfangen (208), über den Eingangsport, eines zweiten Eingangsstroms (104), der größer als der erste Schwellenstrom und kleiner als ein zweiter Schwellenstrom ist;
Erzeugen (210), über die erste SQUID und als Reaktion auf das Empfangen des zweiten Eingangsstroms, des ersten Ausgangs in der Form einer dritten Spannung;
Erzeugen (212), über die zweite SQUID und als Reaktion auf das Empfangen des zweiten Eingangsstroms, des zweiten Ausgangs in der Form der zweiten Spannung;
Empfangen (214), über den Eingangsport, eines dritten Eingangsstroms (104), der größer als der zweite Schwellenstrom ist;
Erzeugen (216), über die erste SQUID und als Reaktion auf das Empfangen des dritten Eingangsstroms, des ersten Ausgangs in der Form der dritten Spannung; und
Erzeugen (218), über die zweite SQUID und als Reaktion auf das Empfangen des dritten Eingangsstroms, des zweiten Ausgangs in der Form einer vierten Spannung, wobei die Diagnoseschaltung (100) dazu konfiguriert ist, eine Ausgangsspannung (112) zu erzeugen, die eine Summe des ersten Ausgangs, des zweiten Ausgangs und des dritten Ausgangs repräsentiert.

2. Verfahren (200) nach Anspruch 1, wobei eine erste Differenz zwischen der ersten Spannung und der dritten Spannung im Wesentlichen gleich einer zweiten Differenz zwischen der zweiten Spannung und der vierten Spannung ist.

3. Verfahren (200) nach Anspruch 1 oder 2, wobei die Diagnoseschaltung (100) aufweist:
einen Eingangsport (102), der dazu konfiguriert ist, einen Eingangsstrom (104) zu empfangen;
eine erste supraleitende Quanteninterferenzeinrichtung, SQUID, (106A), die induktiv mit dem Eingangsport (102) gekoppelt ist, wobei die erste SQUID (106A) dazu konfiguriert ist, einen ersten Ausgang (108A) in der Form von Folgendem zu erzeugen:
einer ersten Spannung als Reaktion darauf, dass der Eingangsstrom (104) kleiner als ein erster Schwellenstrom ist, und
einer zweiten Spannung als Reaktion darauf, dass der Eingangsstrom (104) größer als der erste Schwellenstrom ist; und
eine zweite SQUID (106B), die induktiv mit dem Eingangsport (102) gekoppelt ist, wobei die zweite SQUID (106B) dazu konfiguriert ist, einen zweiten Ausgang (108B) in der Form von Folgendem zu erzeugen:
einer dritten Spannung als Reaktion darauf, dass der Eingangsstrom (104) kleiner als ein zweiter Schwellenstrom ist, und
einer vierten Spannung als Reaktion darauf, dass der Eingangsstrom (104) größer als der zweite Schwellenstrom ist.

4. Diagnoseschaltung (100), die dazu konfiguriert ist, das Verfahren (200) nach einem der vorhergehenden Ansprüche durchzuführen, aufweisend:
einen Eingangsport (102), der dazu konfiguriert ist, einen Eingangsstrom (104) zu empfangen;
eine erste supraleitende Quanteninterferenzeinrichtung, SQUID, (106A), die induktiv mit dem Eingangsport (102) gekoppelt ist, wobei die erste SQUID (106A) dazu konfiguriert ist, einen ersten Ausgang (108A) in der Form von Folgendem zu erzeugen:
einer ersten Spannung als Reaktion darauf, dass der Eingangsstrom (104) kleiner als ein erster Schwellenstrom ist, und
einer zweiten Spannung als Reaktion darauf, dass der Eingangsstrom (104) größer als der erste Schwellenstrom ist; und
eine zweite SQUID (106B), die induktiv mit dem Eingangsport (102) gekoppelt ist,
wobei die zweite SQUID (106B) dazu konfiguriert ist, einen zweiten Ausgang (108B) in der Form von Folgendem zu erzeugen:
einer dritten Spannung als Reaktion darauf, dass der Eingangsstrom (104) kleiner als ein zweiter Schwellenstrom ist, und
einer vierten Spannung als Reaktion darauf, dass der Eingangsstrom (104) größer als der zweite Schwellenstrom ist,
wobei die Diagnoseschaltung (100) dazu konfiguriert ist, eine Ausgangsspannung (112) zu erzeugen, die eine Summe des ersten Ausgangs (108A), des zweiten Ausgangs (108B) und des dritten Ausgangs (108C) repräsentiert.

5. Diagnoseschaltung (100) nach Anspruch 4, wobei die erste SQUID (106A) einen ersten Anschluss (110A) und einen zweiten Anschluss (110B) aufweist und die erste SQUID (106A) dazu konfiguriert ist, den ersten Ausgang (108A) zwischen dem ersten Anschluss (110A) und dem zweiten Anschluss (110B) zu erzeugen.

6. Diagnoseschaltung (100) nach Anspruch 4 oder 5, wobei die zweite SQUID (106B) einen dritten Anschluss (110C) und einen vierten Anschluss (110D) aufweist und die zweite SQUID (106B) dazu konfiguriert ist, den zweiten Ausgang (108B) zwischen dem dritten Anschluss (110C) und dem vierten Anschluss (110D) zu erzeugen.

7. Diagnoseschaltung (100) nach einem der Ansprüche 4 bis 6, wobei der zweite Anschluss (110B) mit dem dritten Anschluss (110C) verbunden ist.

8. Diagnoseschaltung (100) nach einem der Ansprüche 4 bis 7, wobei die erste Spannung im Wesentlichen gleich null ist oder die erste Spannung kleiner als die zweite Spannung ist.

9. Diagnoseschaltung (100) nach einem der Ansprüche 4 bis 8, wobei die dritte Spannung im Wesentlichen gleich null ist oder die dritte Spannung kleiner als die vierte Spannung ist.

10. Diagnoseschaltung (100) nach einem der Ansprüche 4 bis 9, wobei eine erste Differenz zwischen der ersten Spannung und der zweiten Spannung im Wesentlichen gleich einer zweiten Differenz zwischen der dritten Spannung und der vierten Spannung ist.

11. Diagnoseschaltung (100) nach einem der Ansprüche 4 bis 10, wobei der erste Schwellenstrom kleiner als der zweite Schwellenstrom ist.

12. Diagnoseschaltung (100) nach einem der Ansprüche 4 bis 11, des Weiteren aufweisend eine dritte SQUID (106C), die induktiv mit dem Eingangsport (102) gekoppelt ist, wobei die dritte SQUID (106C) dazu konfiguriert ist, einen dritten Ausgang (108C) in der Form von Folgendem zu erzeugen:
einer fünften Spannung als Reaktion darauf, dass der Eingangsstrom (104) kleiner als ein dritter Schwellenstrom ist, und
einer sechsten Spannung als Reaktion darauf, dass der Eingangsstrom (104) größer als der dritte Schwellenstrom ist,
wobei eine erste Differenz zwischen dem ersten Schwellenstrom und dem zweiten Schwellenstrom im Wesentlichen gleich einer zweiten Differenz zwischen dem zweiten Schwellenstrom und dem dritten Schwellenstrom ist.

13. Diagnoseschaltung (100) nach Anspruch 12, wobei die fünfte Spannung im Wesentlichen gleich null ist oder die fünfte Spannung kleiner als die sechste Spannung ist.

14. Diagnoseschaltung (100) nach Anspruch 12, wobei eine dritte Differenz zwischen der ersten Spannung und der zweiten Spannung im Wesentlichen gleich einer vierten Differenz zwischen der dritten Spannung und der vierten Spannung ist, die im Wesentlichen gleich einer fünften Differenz zwischen der fünften Spannung und der sechsten Spannung ist.

## Revendications

1. Procédé (200) de fonctionnement d'un circuit de diagnostic (100), le procédé (200) comprenant:
la réception (202), via un port d'entrée (102) du circuit de diagnostic, d'un premier courant d'entrée (104) qui est inférieur à un premier courant de seuil, dans lequel la réception (202) du premier courant d'entrée comprend la réception du premier courant d'entrée de telle sorte que le premier courant d'entrée représente un état d'un dispositif à semi-conducteur métal-oxyde complémentaire, CMOS, fonctionnant à une température cryogénique, c'est-à-dire une température inférieure ou égale à 4 K correspondant à l'hélium liquide ou inférieure ou égale à 77 K correspondant à l'azote liquide, ledit dispositif CMOS étant à proximité immédiate du circuit de diagnostic (100);
la génération (204), via un premier dispositif supraconducteur à interférence quantique, SQUID, (106A) du circuit de diagnostic et en réponse à la réception du premier courant d'entrée, d'une première sortie (108A) sous la forme d'une première tension;
la génération (206), via un second SQUID (106B) du circuit de diagnostic et en réponse à la réception du premier courant d'entrée, d'une seconde sortie (108B) sous la forme d'une seconde tension;
la réception (208), via le port d'entrée, d'un second courant d'entrée (104) qui est supérieur au premier courant de seuil et inférieur à un second courant de seuil;
la génération (210), via le premier SQUID et en réponse à la réception du second courant d'entrée, de la première sortie sous la forme d'une troisième tension;
la génération (212), via le second SQUID et en réponse à la réception du second courant d'entrée, de la seconde sortie sous la forme de la seconde tension;
la réception (214), via le port d'entrée, d'un troisième courant d'entrée (104) qui est supérieur au second courant de seuil;
la génération (216), via le premier SQUID et en réponse à la réception du troisième courant d'entrée, de la première sortie sous la forme de la troisième tension; et
la génération (218), via le second SQUID et en réponse à la réception du troisième courant d'entrée, de la seconde sortie sous la forme d'une quatrième tension,
ledit circuit de diagnostic (100) étant configuré pour générer une tension de sortie (112) représentant une somme de la première sortie, de la seconde sortie et de la troisième sortie.

2. Procédé (200) selon la revendication 1, dans lequel une première différence entre la première tension et la troisième tension est sensiblement égale à une seconde différence entre la seconde tension et la quatrième tension.

3. Procédé (200) selon la revendication 1 ou 2, dans lequel ledit circuit de diagnostic (100) comprend:
un port d'entrée (102) configuré pour recevoir un courant d'entrée (104);
un premier dispositif supraconducteur à interférence quantique, SQUID, (106A) couplé inductivement au port d'entrée (102), dans lequel le premier SQUID (106A) est configuré pour générer une première sortie (108A) sous la forme de:
une première tension en réponse au fait que le courant d'entrée (104) est inférieur à un premier courant de seuil, et
une seconde tension en réponse au fait que le courant d'entrée (104) est supérieur au premier courant de seuil; et
un second SQUID (106B) couplé inductivement au port d'entrée (102), dans lequel le second SQUID (106B) est configuré pour générer une seconde sortie (108B) sous la forme de:
une troisième tension en réponse au fait que le courant d'entrée (104) est inférieur à un second courant de seuil, et
une quatrième tension en réponse au fait que le courant d'entrée (104) est supérieur au second courant de seuil.

4. Circuit de diagnostic (100) configuré pour mettre en œuvre le procédé (200) selon l'une quelconque des revendications précédentes, comprenant:
un port d'entrée (102) configuré pour recevoir un courant d'entrée (104);
un premier dispositif supraconducteur à interférence quantique, SQUID, (106A) couplé inductivement au port d'entrée (102), dans lequel le premier SQUID (106A) est configuré pour générer une première sortie (108A) sous la forme de:
une première tension en réponse au fait que le courant d'entrée (104) est inférieur à un premier courant de seuil; et
une seconde tension en réponse au fait que le courant d'entrée (104) est supérieur au premier courant de seuil; et
un second SQUID (106B) couplé inductivement au port d'entrée (102), dans lequel le second SQUID (106B) est configuré pour générer une seconde sortie (108B) sous la forme de:
une troisième tension en réponse au fait que le courant d'entrée (104) est inférieur à un second courant de seuil, et
une quatrième tension en réponse au fait que le courant d'entrée (104) est supérieur au second courant de seuil,
dans lequel le circuit de diagnostic (100) est configuré pour générer une tension de sortie (112) représentant une somme de la première sortie (108A), de la seconde sortie (108B) et de la troisième sortie (108C).

5. Circuit de diagnostic (100) selon la revendication 4, dans lequel le premier SQUID (106A) comprend une première borne (110A) et une seconde borne (110B), et le premier SQUID (106A) est configuré pour générer la première sortie (108A) entre la première borne (110A) et la seconde borne (110B).

6. Circuit de diagnostic (100) selon la revendication 4 ou 5, dans lequel le second SQUID (106B) comprend une troisième borne (110C) et une quatrième borne (110D), et le second SQUID (106B) est configuré pour générer la seconde sortie (108B) entre la troisième borne (110C) et la quatrième borne (110D).

7. Circuit de diagnostic (100) selon l'une quelconque des revendications 4 à 6, dans lequel la seconde borne (110B) est connectée à la troisième borne (110C).

8. Circuit de diagnostic (100) selon l'une quelconque des revendications 4 à 7, dans lequel la première tension est sensiblement égale à zéro ou la première tension est inférieure à la seconde tension.

9. Circuit de diagnostic (100) selon l'une quelconque des revendications 4 à 8, dans lequel la troisième tension est sensiblement égale à zéro ou la troisième tension est inférieure à la quatrième tension.

10. Circuit de diagnostic (100) selon l'une quelconque des revendications 4 à 9, dans lequel une première différence entre la première tension et la seconde tension est sensiblement égale à une seconde différence entre la troisième tension et la quatrième tension.

11. Circuit de diagnostic (100) selon l'une quelconque des revendications 4 à 10, dans lequel le premier courant de seuil est inférieur au second courant de seuil.

12. Circuit de diagnostic (100) selon l'une quelconque des revendications 4 à 11, comprenant en outre un troisième SQUID (106C) couplé inductivement au port d'entrée (102), dans lequel le troisième SQUID (106C) est configuré pour générer une troisième sortie (108C) sous la forme de:
une cinquième tension en réponse au fait que le courant d'entrée (104) est inférieur à un troisième courant de seuil, et
une sixième tension en réponse au fait que le courant d'entrée (104) est supérieur au troisième courant de seuil,
dans lequel une première différence entre le premier courant de seuil et le second courant de seuil est sensiblement égale à une seconde différence entre le second courant de seuil et le troisième courant de seuil.

13. Circuit de diagnostic (100) selon la revendication 12, dans lequel la cinquième tension est sensiblement égale à zéro ou la cinquième tension est inférieure à la sixième tension.

14. Circuit de diagnostic (100) selon la revendication 12, dans lequel une troisième différence entre la première tension et la seconde tension est sensiblement égale à une quatrième différence entre la troisième tension et la quatrième tension qui est sensiblement égale à une cinquième différence entre la cinquième tension et la sixième tension.
